# DEMANDE DE BREVET EUROPEEN

(11) **EP 4 175 433 A1**
(43) Date de publication de la demande: **03.05.2023**
(21) Numéro de dépôt: 22204667.4
(22) Date de dépôt: 31.10.2022
(51) Int. Cl.: H05K 7/20

(54) **DISPOSITIF DE REFROIDISSEMENT D'UN COMPOSANT DESTINÉ À ÉQUIPER UN VÉHICULE ET VÉHICULE ASSOCIÉ**

(30) Priorité: 02.11.2021 FR 2111611
(71) Demandeur: ALSTOM Holdings, 93400 Saint-Ouen-sur-Seine (FR)
(72) Inventeur: SCOTTINI, Jonathan, B-1070 Anderlecht (BE); RUCQUOY, Ludovic, 6041 Gosselies (BE); CHENG, Yan, 1560 Hoeilaart (BE)
(74) Mandataire: Lavoix

(57) **Abrégé**

L'invention concerne un dispositif de refroidissement d'un composant (12) destiné à équiper un véhicule. Ledit composant (12) comprend une première face latérale (40) et une deuxième face latérale (42) opposées et des canaux de refroidissement (44) traversant entre la première face latérale (40) et la deuxième face latérale (42). Le dispositif de refroidissement (14) comprend une première ouverture (46), une deuxième ouverture (48) et un ensemble de déflecteurs (50) configuré de telle sorte qu'un déplacement du véhicule (10) génère un flux d'air (F1, F2) entrant par l'une de la première ouverture (46) et de la deuxième ouverture (48) et sortant par l'autre, l'ensemble de déflecteurs (50) étant configuré pour guider le flux d'air (50) en le faisant passer à travers les canaux de refroidissement (44) du composant (12).

## Description

La présente invention concerne un dispositif de refroidissement d'un composant destiné à équiper un véhicule, en particulier un véhicule ferroviaire.

Afin de libérer de la place à l'intérieur du véhicule, des composants, comme par exemple des composants bobinés, sont généralement fixés à l'extérieur de la caisse du véhicule, et plus particulièrement sous la caisse ou en toiture du véhicule.

Les composants bobinés sont propres à générer de la chaleur lors de leur fonctionnement, notamment par perte de chaleur dissipé par effet Joule, et doivent être refroidis pour éviter toute surchauffe.

De tels composants sont généralement refroidis par ventilation naturelle, sans canalisation d'un flux d'air.

Un tel refroidissement présente cependant l'inconvénient de nécessiter un volume important d'intégration sous la caisse ou en toiture du véhicule, afin de permettre la circulation d'une quantité suffisamment importante d'air autour du composant nécessaire au refroidissement de celui-ci.

Or, l'espace disponible sous la caisse ou en toiture du véhicule, notamment en raison de la proximité des différents composants entre eux, est généralement limité et peut ne pas permettre une circulation d'un volume suffisant d'air autour de chacun des composants.

De plus, les turbulences aérauliques engendrées par le mouvement du véhicule perturbent la circulation de l'air, ce qui rend un tel refroidissement peu fiable.

Il est également connu de refroidir de tels composants à l'aide un dispositif de refroidissement forcé, par exemple à l'aide d'un ventilateur ou d'un circuit de pompe à chaleur.

Cependant, en raison de sa consommation énergétique, un tel dispositif de refroidissement est peu économe et augmente l'impact énergétique du véhicule.

De plus, un tel dispositif de refroidissement nécessite des opérations de maintenance supplémentaires pour assurer son fonctionnement et est généralement bruyant.

Un des buts de l'invention est de proposer un dispositif de refroidissement d'un tel composant qui soit économique, à faible impact énergétique et à faible volume, tout en permettant un refroidissement fiable du composant.

Ainsi, l'invention a pour objet un dispositif de refroidissement d'un composant destiné à équiper un véhicule, en particulier un véhicule ferroviaire, prévu pour se déplacer suivant une direction longitudinale, ledit composant comprenant une première face latérale et une deuxième face latérale opposées et des canaux de refroidissement traversant le composant entre la première face latérale et la deuxième face latérale, le dispositif de refroidissement comprenant une première ouverture, une deuxième ouverture et un ensemble de déflecteurs configuré de telle sorte qu'un déplacement du véhicule suivant la direction longitudinale génère un flux d'air entrant par l'une de la première ouverture et de la deuxième ouverture et sortant par l'autre, l'ensemble de déflecteurs étant configuré pour guider le flux d'air en le faisant passer à travers les canaux de refroidissement du composant.

L'utilisation du flux d'air généré par le déplacement du véhicule permet un refroidissement passif du composant sans consommation d'énergie.

De plus, le guidage du flux d'air par l'ensemble de déflecteurs à travers des canaux de refroidissement du composant autorise un refroidissement efficace du composant, quel que soit le sens de circulation du véhicule.

Selon des modes de réalisation particuliers de l'invention, le dispositif de refroidissement présente l'une ou plusieurs des caractéristiques suivantes, prise(s) indépendamment ou selon toute combinaison techniquement réalisable :
- la première ouverture et la deuxième ouverture sont agencées latéralement d'un même côté du composant ;
- l'ensemble de déflecteurs est configuré de telle manière à guider le flux d'air à travers le composant transversalement dans un premier sens transversal en passant par un premier groupe de canaux de refroidissement, puis dans un deuxième sens transversal opposé en passant par un deuxième groupe de canaux de refroidissement ou inversement ;
- l'ensemble de déflecteurs comprend un déflecteur intermédiaire agencé sur l'une de la première face latérale et de la deuxième face latérale du composant pour guider le flux d'air sortant des canaux de refroidissement du premier groupe vers les canaux du deuxième groupe ou inversement ;
- le dispositif de refroidissement comprend un déflecteur intérieur agencé à l'intérieur du composant pour empêcher un écoulement du flux d'air longitudinalement à travers le composant ;
- le déflecteur intérieur s'étend entre la première face latérale et la deuxième face latérale du composant et divise le composant entre une première région et une deuxième région ;
- au moins un canal de refroidissement est agencé dans la première région et au moins un canal refroidissement est agencé dans la deuxième région ;
- le dispositif de refroidissement comprend une première grille disposée en travers de la première ouverture et/ou une deuxième grille disposée en travers de la deuxième ouverture ;
- le dispositif de refroidissement est configuré de telle manière que lorsque le véhicule se déplace dans un premier sens, le flux d'air s'écoule de la première ouverture vers la deuxième ouverture, et lorsque le véhicule se déplace dans un deuxième sens opposé au premier sens, le flux d'air s'écoule de la deuxième ouverture vers la première ouverture.

L'invention concerne également un véhicule, en particulier véhicule ferroviaire, prévu pour se déplacer suivant une direction longitudinale, le véhicule comprenant un composant comprenant une première face latérale et une deuxième face latérale opposées et des canaux de refroidissement traversant le composant en s'étendant entre la première face latérale et la deuxième face latérale, et un dispositif de refroidissement dudit composant tel que décrit précédemment.

L'invention sera mieux comprise à la lecture de la description qui suit, donnée à titre d'exemple et faite en référence aux dessins annexés, parmi lesquels :
- [Fig 1] la figure 1 est une vue de côté d'un véhicule comprenant un dispositif de refroidissement d'un composant selon l'invention sous la caisse du véhicule et un dispositif de refroidissement d'un composant selon l'invention sur le toit du véhicule;
- [Fig 2] la figure 2 est une vue de dessous de deux dispositifs de refroidissement selon l'invention, le véhicule se déplaçant dans un premier sens vers l'avant ; et
- [Fig 3] la figure 3 est une vue de dessous de deux dispositifs de refroidissement selon l'invention, le véhicule se déplaçant dans un deuxième sens opposé au premier sens.

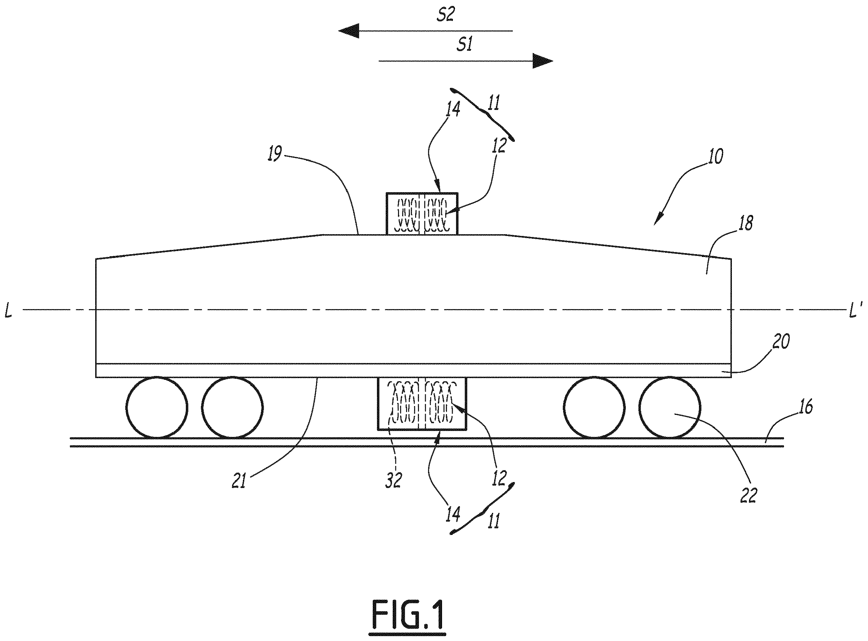

La figure 1 illustre un véhicule 10 équipé de modules 11, chaque module 11 comprenant un composant 12 et un dispositif de refroidissement 14 dudit composant 12.

Le véhicule 10 est par exemple un véhicule ferroviaire ou un véhicule routier, tel qu'un bus.

Le véhicule 10 est prévu pour se déplacer suivant une direction longitudinale L-L' dans un premier sens S1 et/ou dans un deuxième sens S2 opposé au premier sens S1. Le premier sens S1 correspond par exemple à un déplacement vers l'avant du véhicule 10, le deuxième sens S2 correspondant à déplacement vers l'arrière.

Dans le cas où le véhicule 10 est un véhicule ferroviaire comme illustré sur la figure 1, la direction longitudinale L-L' correspond à la direction de rails 16 d'une voie ferrée sur lesquels circule le véhicule ferroviaire 10.

Dans tout ce qui suit, les orientations sont les orientations habituelles d'un véhicule. Ainsi, les termes « avant », « arrière », « gauche », « droit », « haut », « bas », « longitudinal », « transversal » et « vertical » s'entendent par rapport au premier sens S1 de déplacement du véhicule 10 vers l'avant.

Le véhicule 10 comprend une caisse 18 définissant un toit 19 et un bas de caisse 20 et des roues 22 montées sous le bas de caisse 20. Les roues 22 supportent le véhicule 10. Dans le cas d'un véhicule 10 ferroviaire, les roues 22 roulent sur les rails 16.

Le toit 19 désigne la partie supérieure de la caisse 18.

Le bas de caisse 20 désigne la partie inférieure de la caisse 18.

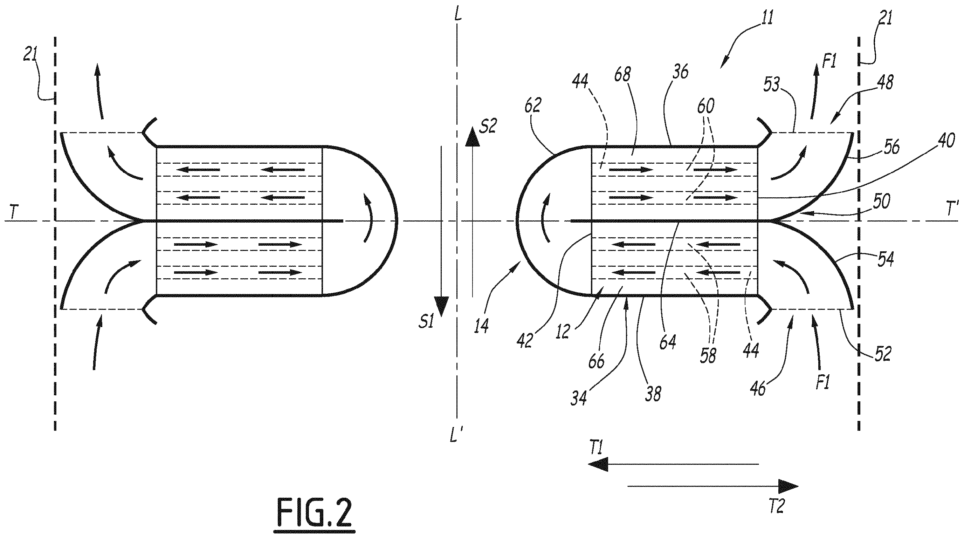

Comme visible sur la Figure 2, chacun du toit 19 et du bas de caisse 20 définit deux bords longitudinaux 21 opposés l'un de l'autre et correspondant par exemple à un bord droit et un bord gauche du bas de caisse 20, respectivement du toit 19.

Chaque module 11 est fixé à l'extérieur de la caisse 18 du véhicule 10, et en particulier sous le bas de caisse 20 ou sur le toit 19.

Comme illustré sur la figure 2, les modules 11 sont avantageusement fixés par paire soit sous le bas de caisse 20 soit sur le toit 19 du véhicule 10.

Les deux modules 11 d'une paire sont par exemple symétriques par rapport à un plan longitudinal médian du véhicule 10. Le plan longitudinal médian du véhicule 10 est défini comme le plan vertical passant par une droite parallèle à la direction longitudinale L-L' et partageant le véhicule 10 en partie droite et une partie gauche.

Chacun des deux modules 11 est disposé à proximité d'un bord respectif parmi les deux bords longitudinaux 21 droite ou gauche du bas de caisse 20 , respectivement du toit 19.

Les deux modules 11 d'une même paire étant analogues, seul le module 11 situé à droite sur la figure 2 sera décrit dans la suite de la description.

En fonctionnement, le composant 12 génère de la chaleur, en particulier lorsque le véhicule 10 est en mouvement et se déplace suivant la direction longitudinale L-L'.

Comme illustré sur la figure 1, le composant 12 est par exemple un composant bobiné, i.e. un composant comportant une bobine 32.

En cours de fonctionnement, un tel composant 12 génère des pertes de chaleur par effet Joule.

La bobine 32 est par exemple une bobine d'inductance de type sec, notamment une bobine utilisant une isolation à base de résine.

De préférence, le composant 12 génère des pertes de chaleur uniquement lorsque le véhicule 10 est en mouvement. Le composant 12 ne génère pas de pertes de chaleur lorsque le véhicule 10 est à l'arrêt.

Le composant 12 est par exemple un élément du dispositif de traction du véhicule 10, i.e. le dispositif générant la force de traction du véhicule. Le composant 12 est par exemple un transformateur de traction.

En variante, le composant 12 est un composant électronique, comme par exemple une résistance ou un ensemble de résistances de frein.

Le composant 12 est avantageusement logé dans une carcasse 34.

La carcasse 34 définit une face arrière 36, une face avant 38, une première face latérale 40 et une deuxième face latérale 42 du composant 12.

La face arrière 36 et la face avant 38 du composant 12 s'étendent sensiblement perpendiculairement à la direction longitudinale L-L'.

La première et la deuxième faces latérales 40, 42 du composant 12 s'étendent sensiblement parallèlement à la direction longitudinale L-L'.

La première face latérale 40 du composant 12 se situe à proximité de l'un des bords longitudinaux 21 droite ou gauche du bas de caisse 20, respectivement du toit 19, et la deuxième face latérale 42 du composant 12 est éloignée dudit bord longitudinal 21, en étant décalée transversalement vers le milieu de la caisse 18 par rapport à la première face latérale 40.

Le composant 12 comprend, en outre, des canaux de refroidissement 44 traversant le composant 12 entre la première face latérale 40 et la deuxième face latérale 42.

Chaque canal de refroidissement 44 définit un passage autorisant le passage d'air à travers le composant 12 entre la première face latérale 40 et la deuxième face latérale 42, de sorte à refroidir ledit composant 12.

Comme illustré sur la figure 2, les canaux de refroidissement 44 sont parallèles entre eux et s'étendent selon une direction transversale T-T' perpendiculaire à la direction longitudinale L-L'.

Les canaux de refroidissement 44 sont sensiblement parallèles aux faces arrière 36 et avant 38 du composant 12.

Le composant 12 comprend au moins deux canaux de refroidissement 44 espacés l'un de l'autre selon la direction longitudinale L-L'.

Le dispositif de refroidissement 14 du composant 12 comprend une première ouverture 46, une deuxième ouverture 48 et un ensemble de déflecteurs 50.

La première et la deuxième ouverture 46, 48 sont aptes à laisser entrer dans le module 11 et sortir du module 11 un flux d'air F1, F2 généré du fait du déplacement du véhicule suivant la direction longitudinale L-L'.

Le flux d'air F1, F2 est ainsi généré selon une direction parallèle à la direction longitudinale L-L' et est orienté relativement au véhicule 10 dans le sens inverse du sens de déplacement du véhicule 10.

Par exemple, comme illustré sur la figure 2, lorsque le véhicule circule dans le premier sens S1 vers l'avant du véhicule 10, le flux d'air F1 est orienté relativement au module 11 dans le deuxième sens S2.

Lorsque le véhicule circule dans le premier sens S1, le flux d'air F1 entre parallèlement à la direction longitudinale L-L' par la première ouverture 46 et sort par la deuxième ouverture 48.

Lorsque le véhicule circule dans le deuxième sens S2, le flux d'air F2 entre parallèlement à la direction longitudinale L-L' par la deuxième ouverture 48 et sort par la première ouverture 46.

Dans un exemple de réalisation, la première ouverture 46 est tournée vers l'avant et la deuxième ouverture 48 est tournée vers l'arrière.

De préférence, la première ouverture 46 est orientée suivant la direction longitudinal L-L' dans le premier sens S1 et la deuxième ouverture 48 est orientée suivant la direction longitudinal L-L' dans le deuxième sens S2.

Avantageusement, la première ouverture 46 et la deuxième ouverture 48 sont agencées latéralement d'un même côté du composant 12.

Autrement dit, la première ouverture 46 et la deuxième ouverture 48 sont disposées à proximité de la même face latérale 40du composant 12.

Avantageusement, comme illustré sur la figure 2, la première ouverture 46 et la deuxième ouverture 48 sont disposées à proximité de la première face latérale 40 du composant 12 située à proximité de l'un des bords longitudinaux 21 droite ou gauche du bas de caisse 20, respectivement du toit 19.

Une telle disposition des ouvertures (première ouverture 46 et deuxième ouverture 48) adjacentes à un bord longitudinal 21 offre l'avantage de permettre une entrée d'un volume d'air plus important que si les ouvertures étaient décalées vers le milieu de la caisse 18.

Avantageusement, une première grille 52 est disposée en travers de la première ouverture 46.

Avantageusement, une deuxième grille 53 est également disposée en travers de la deuxième ouverture 48.

Chaque grille (première grille 52 ou deuxième grille 53) est configurée pour permettre l'entrée d'air et la sortie d'air à travers l'ouverture correspondante (première ouverture 46 ou deuxième ouverture 48) tout en filtrant des impuretés, telles que des projections importantes de ballast et autres déchets de surface . De tels impuretés pourraient endommager le composant 12 et/ou boucher les ouvertures 46, 48 .

L'ensemble de déflecteur 50 est configuré de sorte à guider le flux d'air F1, F2 entrant par l'une de la première ouverture 46 et de la deuxième ouverture 48 et sortant par l'autre en le faisant passer à travers les canaux de refroidissement 44 du composant 12.

L'ensemble de déflecteurs 50 est ainsi configuré pour dévier horizontalement le flux d'air F1, F2.

Par exemple si le véhicule circule dans le premier sens S1 comme illustré sur la figure 2, le flux d'air F1 entre par la première ouverture 46 suivant la direction longitudinale L-L' et orienté vers l'arrière dans le deuxième sens S2. L'ensemble de déflecteurs 50 dévie le flux d'air F1 pour le faire circuler suivant la direction transversale T-T' à travers les canaux de refroidissement 44 du composant 12.

L'ensemble de déflecteurs 50 est également configuré pour dévier le flux d'air F1 sortant des canaux de refroidissement 44 suivant la direction transversale T-T' de telle sorte que le flux d'air F1 puisse sortir par la deuxième ouverture 48, ici suivant la direction longitudinale L-L'.

L'ensemble de déflecteur 50 comprend par exemple un premier déflecteur 54 agencé pour dévier horizontalement un flux d'air F1, F2 entrant ou sortant par la première ouverture 46 et un deuxième déflecteur 56 agencé pour dévier horizontalement un flux d'air F1, F2 entrant ou sortant par la deuxième ouverture 48.

Comme illustré sur la figure 2, chacun du premier et du deuxième déflecteurs 54, 56 est par exemple coudé, en particulier en forme de quart de cercle, et s'étend entre la première face latérale 40 du composant 12 et l'ouverture correspondante parmi la première ouverture 46 et la deuxième ouverture 48, de telle sorte à dévier le flux d'air F1, F2 d'un angle de 90°.

Le premier déflecteur 54 et le deuxième déflecteur 56 forment chacun une écope pour récupérer le flux d'air F1, F2 généré du fait du déplacement du véhicule et le guider vers les canaux de refroidissement 44 du composant 12.

Dans le mode de réalisation de l'invention illustré sur la figure 2, l'ensemble de déflecteurs 50 est configuré de telle manière à, au cours du déplacement du véhicule 10 selon le premier sens S1, guider le flux d'air F1 à travers le composant 12 transversalement dans un premier sens transversal T1 en passant par un premier groupe 58 de canaux de refroidissement 44, puis dans un deuxième sens transversal T2 opposé en passant par un deuxième groupe 60 de canaux de refroidissement 44. Le premier groupe 58 et le deuxième groupe 60 sont distincts.

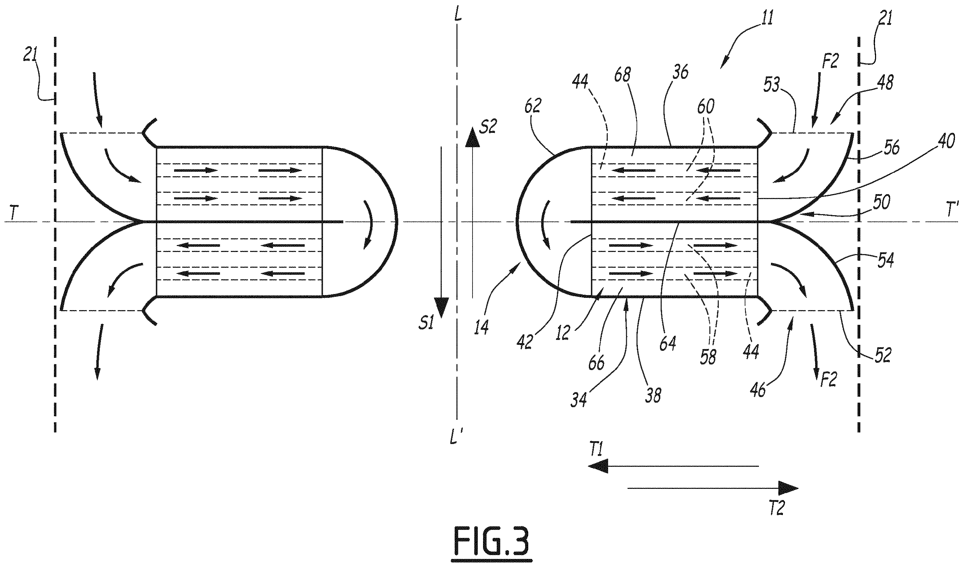

Plus particulièrement, la première ouverture 46 et la deuxième ouverture 48 étant disposées à proximité de la première face latérale 40 du composant 12, l'ensemble de déflecteurs 50 est configuré de telle manière à guider le flux d'air F1 à travers le composant 12 dans un premier sens transversal T1 allant de la première face latérale 40 à la deuxième face latérale 42 puis dans un deuxième sens transversal T2 opposé allant de la deuxième face latérale 42 à la première face latérale 40. Comme illustré sur la figure 3, de manière inverse, au cours du déplacement du véhicule 10 selon le deuxième sens S2, l'ensemble de déflecteurs 50 est configuré de telle manière à guider le flux d'air F2 à travers le composant 12 transversalement dans le deuxième sens transversal T2 en passant par le deuxième groupe 60 de canaux de refroidissement, puis dans le premier sens transversal T1 opposé en passant par le premier groupe 58 de canaux de refroidissement 44.

Le premier groupe 58 comprend le canal ou les canaux de refroidissement 44 le(s) plus proche(s) de la face avant 38 du composant 12 et le deuxième groupe 60 comprend le canal ou les canaux de refroidissement 44 le(s) plus proche(s) de la face arrière 36 du composant 12.

L'ensemble de déflecteur 50 comprend par exemple un déflecteur intermédiaire 62 agencé sur l'une de la première face latérale 40 et de la deuxième face latérale 42 pour guider le flux d'air F1 sortant des canaux de refroidissement 44 du premier groupe 58 vers les canaux de refroidissement 44 du deuxième groupe 60, ou inversement.

En particulier, le déflecteur intermédiaire 62 est agencé sur la deuxième face latérale 42 pour, au cours du déplacement du véhicule 10 selon le premier sens S1, guider le flux d'air F1 sortant des canaux de refroidissement 44 du premier groupe 58 vers les canaux de refroidissement 44 du deuxième groupe 60 et pour, au cours du déplacement du véhicule 10 selon le deuxième sens S2, guider le flux d'air F2 sortant des canaux de refroidissement 44 du deuxième groupe 60 vers les canaux de refroidissement 44 du premier groupe 58.Le déflecteur intermédiaire 62 est configuré pour dévier le flux d'air F1, F2 horizontalement en lui faisant faire un demi-tour, i.e. à dévier le flux d'air horizontalement de 180°.

Le déflecteur intermédiaire 62 a par exemple une forme en demi-cercle et est disposé sur la deuxième face latérale 42 pour récupérer de l'air sortant de canaux de refroidissement 44 du premier groupe 58 et le guider vers les canaux de refroidissement 44 du deuxième groupe 60, ou inversement.

Avantageusement, l'ensemble de déflecteur 50 comprend, en outre, un déflecteur intérieur 64 agencé à l'intérieur du composant 12 pour empêcher un écoulement du flux d'air F1, F2 longitudinalement à travers le composant 12.

Les canaux de refroidissement 44 du premier groupe 58 sont situés dans une première région 66 du composant 12 adjacente à la face avant 38, et les canaux de refroidissement 44 du deuxième groupe 60 sont situés dans une deuxième région 68 du composant 12 adjacente à la face arrière 36 du composant 12.

Le déflecteur intérieur 64 s'étend, avantageusement, perpendiculairement à la direction longitudinale L-L' et empêche un écoulement du flux d'air F1, F2 à l'intérieur du composant 12 entre la première région 66 et la deuxième région 68 du composant 12.

Comme illustré sur la figure 2, le déflecteur intérieur 64 s'étend entre la première face latérale 40 et la deuxième face latérale 42 du composant 12 et divise le composant 12 entre la première région 66 et la deuxième région 68.

Le déflecteur intérieur 64 est par exemple une plaque disposée à l'intérieur du composant 12 et formant une barrière transversale entre la première région 66 avant et la deuxième région 68 arrière du composant 12.

Au moins un canal de refroidissement 44 est agencé dans la première région 66 et au moins un canal refroidissement 44 est agencé dans la deuxième région 68.

Comme illustré sur la figure 2, les canaux de refroidissement 44 du premier groupe 58 sont agencés dans la première région 66 avant et les canaux de refroidissement 44 du deuxième groupe 60 sont agencés dans la deuxième région 68 arrière.

Une méthode de refroidissement du composant 12 à l'aide du dispositif de refroidissement 14 va maintenant être décrit dans le cas où le véhicule 10 se déplace suivant la direction longitudinale L-L' dans le premier sens S1 vers l'avant, en référence à la figure 2.

Le déplacement du véhicule 10 suivant la direction longitudinale L-L' dans le premier sens S1 génère un flux d'air F1 suivant la direction longitudinale L-L' dans le deuxième sens S2 vers l'arrière.

Le flux d'air F1 entre par la première ouverture 46.

Avantageusement, les impuretés, tel que des projections de ballast et autres déchets de surface, potentiellement présentes dans l'air, sont filtrées par la première grille 52 lors du passage de l'air à travers la première ouverture 46.

Le premier déflecteur 54 dévie ensuite horizontalement le flux d'air F1, et plus particulièrement d'un angle de 90°.

Le flux d'air F1 est ainsi orienté dans la direction transversale T-T' perpendiculaire à la direction longitudinale L-L' et entre dans le ou les canaux de refroidissement 44 du premier groupe 58 par la première face latérale 40 du composant 12.

Le flux d'air F1 traverse le ou les canaux de refroidissement 44 du premier groupe 58 dans le premier sens transversal T1 allant de la première face latérale 40 à la deuxième face latérale 42 du composant 12.

Un tel passage du flux d'air F1 dans le ou les canaux de refroidissement 44 du premier groupe 58 refroidit l'intérieur du composant 12, et plus particulièrement la première région 66 avant du composant 12.

Le flux d'air F1 sort ensuite des canaux de refroidissement 44 du premier groupe 58 par la deuxième face latérale 42 du composant 12.

Le flux d'air F1 est ensuite dévié par le déflecteur intermédiaire 62, et plus particulièrement d'un angle de 180°.

Le flux d'air F1 ainsi dévié entre ensuite dans les canaux de refroidissement 44 du deuxième groupe 60 par la deuxième face latérale 42 du composant 12.

Le flux d'air F1 traverse les canaux de refroidissement 44 du deuxième groupe 60 dans le deuxième sens transversal T2 allant de la deuxième face latérale 42 à la première face latérale 40 du composant 12.

Un tel passage du flux d'air F1 dans les canaux de refroidissement 44 du deuxième groupe 60 refroidit l'intérieur du composant 12, et plus particulièrement la deuxième région 68 arrière du composant 12.

Le flux d'air F1 sort ensuite des canaux de refroidissement 44 du deuxième groupe 60 par la première face latérale 40 du composant 12.

Le flux d'air F1 est ensuite dévié par le deuxième déflecteur 56 et notamment d'un angle de 90°.

Le flux d'air F1 ainsi dévié sort par la deuxième ouverture 48.

Lorsque le véhicule se déplace dans le premier sens S1, le flux d'air F1 s'écoule ainsi de la première ouverture 46 vers la deuxième ouverture 48.

Le composant 12 est ainsi refroidi en continu par le flux d'air F1 généré par le déplacement du véhicule 10 et guidé par le dispositif de refroidissement 14.

Comme illustré sur la figure 3, dans le cas où le véhicule 10 se déplace suivant la direction longitudinale L-L' dans le deuxième sens S2 vers l'arrière, la méthode de refroidissement du composant 12 à l'aide du dispositif de refroidissement 14 est identique. Le flux d'air F2 circule dans le sens inverse à l'intérieur du module 11.

Lorsque le véhicule se déplace dans le deuxième sens S2 vers l'arrière, le flux d'air F2 s'écoule de la deuxième ouverture 48 vers la première ouverture 46.

Un tel dispositif de refroidissement 14 autorise un refroidissement efficace du composant 12.

Le guidage du flux d'air F1, F2 par l'ensemble de déflecteurs 50 assure un refroidissement du composant 12 fiable et peu sensible aux turbulences aérauliques.

De plus, l'utilisation du flux d'air F1, F2 généré par le déplacement du véhicule 10 autorise un refroidissement passif du composant 12, et donc économique et sans impact énergétique. L'air traversant le composant 12 circule du seul fait du déplacement du véhicule 10.

En outre, la disposition des ouvertures 46, 48 à proximité des bords 21 du bas de caisse 20, respectivement du toit 19, permet d'assurer une aspiration d'un volume d'air suffisamment important.

Par ailleurs, le passage du flux d'air F1, F2 dans les canaux de refroidissement 44 répartis en une première région 66 et une deuxième région 68 assure un refroidissement homogène du composant 12.

En variante non-illustrée, la première ouverture 46 et la deuxième ouverture 48 sont disposées à proximité des faces latérale 40,42 différentes du composant 12.

Dans le cas où le module 11 est par exemple de grandes dimensions et occupe toute la largeur du bas de caisse 20 ou du toit 19, les deux faces latérales 40, 42 sont à proximité d'un des bords longitudinaux 21 du bas de caisse 20, respectivement du toit 19. Les deux ouvertures 46, 48 sont donc à proximité de l'extérieur du véhicule 10 et sont donc aptes à aspirer suffisamment de volume d'air pour refroidir le composant 12.

En outre, dans le cas où le dispositif de refroidissement 14 équipe un véhicule 10 routier. Un fonctionnement symétrique du dispositif de refroidissement 14 n'est pas nécessaire.

## Revendications

1. Module (11) comprenant un composant (12) et un dispositif de refroidissement (14) du composant (12), le module (11) étant destiné à équiper un véhicule (10), en particulier un véhicule ferroviaire, prévu pour se déplacer suivant une direction longitudinale (L-L'), ledit composant (12) comprenant une première face latérale (40) et une deuxième face latérale (42) opposées et des canaux de refroidissement (44) traversant le composant (12) entre la première face latérale (40) et la deuxième face latérale (42), le dispositif de refroidissement (14) comprenant une première ouverture (46), une deuxième ouverture (48) et un ensemble de déflecteurs (50) configuré de telle sorte qu'un déplacement du véhicule (10) suivant la direction longitudinale (L-L') génère un flux d'air (F1, F2) entrant par l'une de la première ouverture (46) et de la deuxième ouverture (48) et sortant par l'autre, l'ensemble de déflecteurs (50) étant configuré pour guider le flux d'air (50) en le faisant passer à travers les canaux de refroidissement (44) du composant (12), la première ouverture (46) et la deuxième ouverture (48) étant agencées latéralement d'un même côté du composant (12).

2. Module selon la revendication 1, dans lequel l'ensemble de déflecteurs (50) est configuré de telle manière à guider le flux d'air (F1, F2) à travers le composant (12) transversalement dans un premier sens transversal (T1) en passant par un premier groupe (58) de canaux de refroidissement (44), puis dans un deuxième sens transversal (T2) opposé en passant par un deuxième groupe (60) de canaux de refroidissement (44) ou inversement.

3. Module selon la revendication 2, dans lequel l'ensemble de déflecteurs (50) comprend un déflecteur intermédiaire (62) agencé sur l'une de la première face latérale (40) et de la deuxième face latérale (42) du composant (12) pour guider le flux d'air (F1, F2) sortant des canaux de refroidissement (44) du premier groupe (58) vers les canaux (44) du deuxième groupe (60) ou inversement.

4. Module selon l'une quelconque des revendications précédentes, dans lequel le dispositif de refroidissement (14)comprend un déflecteur intérieur (64) agencé à l'intérieur du composant (12) pour empêcher un écoulement du flux d'air (F1, F2) longitudinalement à travers le composant (12).

5. Module selon la revendication 4, dans lequel le déflecteur intérieur (64) s'étend entre la première face latérale (40) et la deuxième face latérale (42) du composant (12) et divise le composant (12) entre une première région (66) et une deuxième région (68).

6. Module selon la revendication 5, dans lequel au moins un canal de refroidissement (44) est agencé dans la première région (66) et au moins un canal refroidissement (44) est agencé dans la deuxième région (68).

7. Module selon l'une quelconque des revendications précédentes, dans lequel le dispositif de refroidissement (14) comprend une première grille (52) disposée en travers de la première ouverture (46) et/ou une deuxième grille (53) disposée en travers de la deuxième ouverture (48).

8. Module selon l'une quelconque des revendications précédentes, configuré de telle manière que lorsque le véhicule (10) se déplace dans un premier sens (S1), le flux d'air (F1) s'écoule de la première ouverture (46) vers la deuxième ouverture (48), et lorsque le véhicule (10) se déplace dans un deuxième sens (S2) opposé au premier sens (S1), le flux d'air (F2) s'écoule de la deuxième ouverture (48) vers la première ouverture (46).

9. Véhicule, en particulier véhicule ferroviaire, prévu pour se déplacer suivant une direction longitudinale (L-L'), le véhicule (10) comprenant un module (11) selon l'une quelconque des revendications précédentes.
